# EUROPEAN PATENT APPLICATION

(11) **EP 3 503 396 A1**
(43) Date of publication of application: **26.06.2019**
(21) Application number: 18199402.1
(22) Date of filing: 09.10.2018
(51) Int. Cl.: H03K 17/14

(54) **SEMICONDUCTOR DEVICE, SENSOR TERMINAL, AND SEMICONDUCTOR DEVICE CONTROL METHOD**

(30) Priority: 19.12.2017 JP 2017242402
(71) Applicant: Renesas Electronics Corporation, 135-0061 Tokyo (JP)
(72) Inventor: MATSUDAIRA, Masaharu, Koutou-ku,, Tokyo 135-0061, (JP); HASE, Takashi, Koutou-ku,, Tokyo 135-0061, (JP); TANABE, Akira, Koutou-ku,, Tokyo 135-0061, (JP); UEJIMA, Kazuya, Koutou-ku,, Tokyo 135-0061, (JP)
(74) Representative: Betten & Resch

(57) **Abstract**

There is a need to ensure operations at a predetermined operating frequency when a temperature changes in an operating state. A semiconductor device includes: a bias-applied portion applied with a substrate bias; a temperature sensor to detect a temperature; and a substrate bias generator to apply the bias-applied portion with a substrate bias corresponding to the temperature detected by the temperature sensor. The bias-applied portion, while applied with a substrate bias by the substrate bias generator, shifts between an operating state and a stopped state. The substrate bias generator applies the bias-applied portion with a substrate bias configured so as not to cause an upper limit of an operating frequency for the bias-applied portion to be smaller than a predetermined value under condition of the temperature detected by the temperature sensor.

## Description

### CROSS-REFERENCE TO RELATED APPLICATIONS

The disclosure of Japanese Patent Application No.2017-242402 filed on December 19, 2017 including the specification, drawings and abstract is incorporated herein by reference in its entirety.

### BACKGROUND

The present invention relates to a semiconductor device and more particularly to a semiconductor device to provide substrate bias control that applies a substrate bias to a bias-applied portion.

In order to reduce a leakage current in a semiconductor device, a substrate bias control may be provided to apply a substrate bias to a substrate region of a targeted circuit portion. A leakage current in the semiconductor device varies with the temperature and increases at a high temperature.

For example, the technology described in patent literature 1 detects the temperature in real time and varies a substrate bias supplied to a function block depending on the detected temperature. It is therefore possible to reduce a leakage current despite a temperature change (particularly changing to a high temperature) by varying the substrate bias depending on the temperature compared to keeping the substrate bias constant.

Patent literature 1: Japanese Unexamined Patent Application Publication No. 2014-116014

### SUMMARY

As above, the technology disclosed in patent literature 1 reduces a leakage current by controlling a substrate bias. Generally, leakage currents are prevailing as currents in a standby state of the semiconductor device. The technology disclosed in patent literature 1 is therefore considered to reduce a leakage current in the standby state.

The semiconductor device needs to ensure operations at a predetermined operating frequency during an operating state. When the temperature changes, it is necessary to prevent the upper limit of the operating frequency from becoming lower than the predetermined operating frequency. However, the technology disclosed in patent literature 1 reduces a leakage current in the standby state and therefore cannot ensure operations at a predetermined operating frequency when the temperature changes in the operating state.

These and other objects and novel features may be readily ascertained by referring to the following description of the present specification and appended drawings.

According to an embodiment, a semiconductor device includes: a bias-applied portion applied with a substrate bias; a temperature sensor to detect a temperature; and a substrate bias generator to apply the bias-applied portion with a substrate bias corresponding to the temperature detected by the temperature sensor. The bias-applied portion, while applied with a substrate bias by the substrate bias generator, shifts between an operating state and a stopped state. The substrate bias generator applies the bias-applied portion with a substrate bias configured so as not to allow an upper limit of an operating frequency for the bias-applied portion to be smaller than a predetermined value under condition of the temperature detected by the temperature sensor.

The above-mentioned embodiment can help solve the above-mentioned issue.

### BRIEF DESCRIPTION OF THE DRAWINGS

FIG. 1A is a diagram illustrating general characteristics of a transistor;
FIG. 1B is a circuit diagram of a general inverter circuit;
FIG. 1C is a sectional view of a general inverter circuit;
FIG. 2 is a diagram illustrating general characteristics of a semiconductor device using a transistor having the characteristics illustrated in FIG. 1A;
FIG. 3 is a block diagram illustrating a configuration of a semiconductor device according to a basic example;
FIG. 4 is a diagram illustrating a substrate bias according to the basic example;
FIG. 5 is a diagram illustrating a state in which the semiconductor device according to the basic example operates at a high-temperature side;
FIG. 6 is a diagram illustrating a state in which the semiconductor device according to the basic example operates at a low-temperature side;
FIG. 7 is a block diagram illustrating a configuration of the semiconductor device according to a first embodiment;
FIG. 8 is a diagram illustrating a substrate bias according to the first embodiment;
FIG. 9 is a diagram illustrating temperature dependency of the upper limit of operating frequencies for a bias-applied portion according to the first embodiment corresponding to power supply voltages;
FIG. 10 is a diagram illustrating a state in which the semiconductor device according to the first embodiment operates at a high-temperature side;
FIG. 11 is a diagram illustrating a state in which the semiconductor device according to the first embodiment operates at a low-temperature side;
FIG. 12 is a timing chart illustrating operation timing of the semiconductor device according to the first embodiment;
FIG. 13 is a block diagram illustrating a configuration of the semiconductor device according to a second embodiment;
FIG. 14 is a diagram illustrating a substrate bias according to the second embodiment;
FIG. 15 is a diagram illustrating a substrate bias according to the second embodiment;
FIG. 16 is a diagram illustrating a state in which the semiconductor device according to the second embodiment operates at a low-temperature side;
FIG. 17 is a diagram illustrating a state in which the semiconductor device according to the second embodiment operates at a high-temperature side;
FIG. 18 is a block diagram illustrating a configuration of the semiconductor device according to a third embodiment;
FIG. 19 is a block diagram illustrating a configuration of a sensor terminal using the semiconductor device according to the embodiment;
FIG. 20 illustrates an example of setting a reference voltage generated by a reference voltage generator according to the first embodiment; and
FIG. 21 illustrates a modification of substrate bias control according to the first and second embodiments.

### DETAILED DESCRIPTION

The following description and drawings are omitted and simplified as needed in order to clarify the explanation. In the drawings, mutually corresponding elements are designated by the same reference symbols and a duplicate explanation is omitted as needed. Specific numerical values used in the embodiments are merely given as examples to facilitate understanding of the invention and are not limited thereto.

### Use conditions for the embodiments

The description below first explains use conditions assumed in the embodiments described later.

Recently, semiconductor devices are increasingly applied to sensor terminals oriented toward IoT (Internet of Things) or systems using an energy harvesting power supply. There is also an increasing need to decrease power supply voltages, improve processing speeds, and respond to temperature changes.

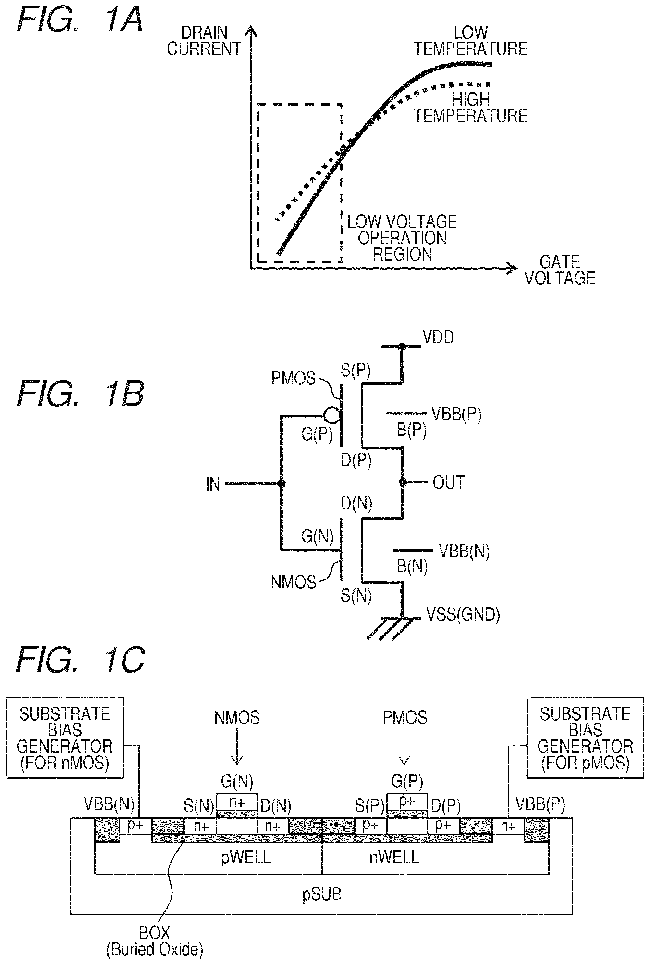

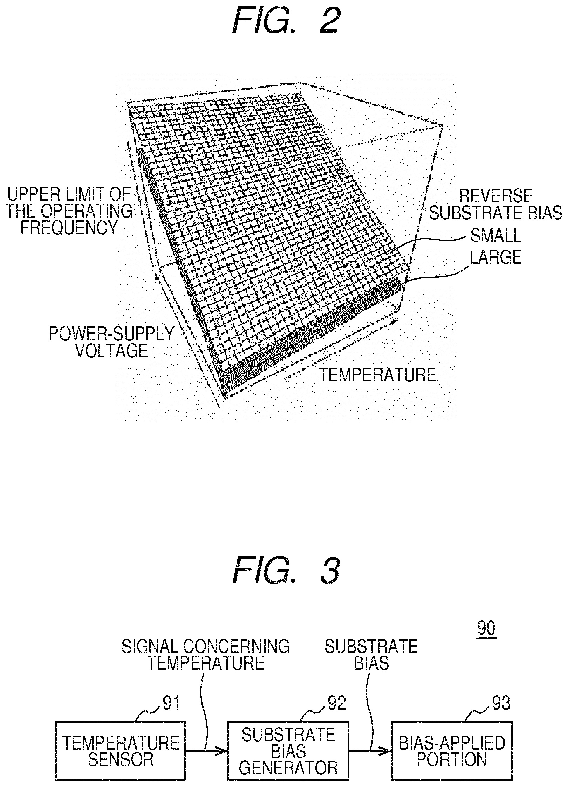

With reference to FIGS. 1A, 1B, 1C, and 2, the description below explains general characteristics of a transistor and general characteristics of a semiconductor device using the transistor.

As illustrated in FIG. 1A, a transistor is generally characterized by decreasing a drain current at a low temperature in a region where a gate voltage is low.

Operating a semiconductor device using the transistor characterized as illustrated in FIG. 1A in a low power supply voltage region decreases a gate voltage of the transistor. A drain current therefore decreases at a low temperature.

An inverter circuit illustrated in FIGS. 1B and 1C is used as an example to explain electric potentials applied to a PMOS transistor and an NMOS transistor. Power supply voltage VDD is applied to source electrode S (P) of the PMOS transistor. Ground voltage VSS (GND) is applied to source electrode S (N) of the NMOS transistor. Gate terminal G (P) of the PMOS transistor and gate terminal G (N) of the NMOS transistor are mutually coupled to provide input terminal IN of the inverter circuit. Drain terminal D (P) of the PMOS transistor and drain terminal D (P) of the NMOS transistor are mutually coupled to provide output terminal OUT of the inverter circuit. Usually, power supply voltage VDD is applied to substrate terminal B (P) of the PMOS transistor. It is possible to control characteristics of the PMOS transistor by applying substrate bias VBB (P) as a voltage independent of power supply voltage VDD. Substrate bias VBB (P) is generated from a substrate bias generator (for PMOS), for example, and is applied to an n-well region below the PMOS transistor. Similarly, ground potential VSS is usually applied to substrate terminal B (N) of the NMOS transistor. It is possible to control characteristics of the NMOS transistor by applying substrate bias VBB (N) as a voltage independent of the ground voltage. Substrate bias VBB (N) is generated from a substrate bias generator (for NMOS), for example, and is applied to a p-well region below the NMOS transistor. Increasing a drain current for the PMOS transistor or the NMOS transistor improves the operating frequency of the inverter circuit, and decreasing the drain current for the PMOS transistor or the NMOS transistor degrades the operating frequency of the inverter circuit.

As illustrated in FIG. 2, the semiconductor device using the transistor characterized as illustrated in FIG. 1A decreases the upper limit of the operating frequency at a low temperature due to a decrease in the drain current at a low temperature.

The semiconductor device has been characterized by decreasing the upper limit of the operating frequency at a high temperature in a high power supply voltage region. As above, the phenomenon of decreasing the upper limit of the operating frequency at a low temperature in a low power supply voltage region reveals a new issue as a result of decreasing the power supply voltage for the semiconductor device. As illustrated in FIG. 2, applying a reverse substrate bias to the semiconductor device also varies the upper limit of the operating frequency.

For the semiconductor device, the low power supply voltage, the low temperature, and application of the reverse substrate bias therefore provide a worst-case condition in terms of ensuring the upper limit of the operating frequency.

The embodiments to be described below assume that the semiconductor device ensures the upper limit of the operating frequency in the operating state under the worst-case condition of the low power supply voltage, the low temperature, and application of the reverse substrate bias. The low power supply voltage is assumed to be 1 V or lower, for example. The low temperature is assumed to be -5 °C or lower, for example. However, the numerical values are merely given as examples to facilitate understanding of the invention and are not limited thereto.

### Basic example

The description below explains a basic example as the basis for the embodiments to be described below.

### Configuration of the basic example

With reference to FIG. 3, the description below explains an example configuration of a semiconductor device 90 according to the basic example. As illustrated in FIG. 3, the semiconductor device 90 according to the basic example includes a temperature sensor 91, a substrate bias generator 92, and a bias-applied portion 93.

The temperature sensor 91 detects the temperature and outputs a signal concerning the detected temperature to the substrate bias generator 92. The temperature sensor 91 is provided for the semiconductor device 90. The temperature detected by the temperature sensor 91 therefore equals the temperature of the environment where the semiconductor device 90 is installed.

The substrate bias generator 92 generates a substrate bias corresponding to the temperature detected by the temperature sensor 91 and applies the generated substrate bias to a substrate region of the bias-applied portion 93. The substrate bias includes either or both a substrate bias for the PMOS transistor and a substrate bias for the NMOS transistor.

The substrate bias generator 92 applies the substrate bias to the substrate region of the bias-applied portion 93. The bias-applied portion 93 is provided as a circuit portion that can shift between at least an operating state and a stopped state and can define an operating frequency (processing speed).

The bias-applied portion 93 shifts between the operating state and the stopped state in such a state that the substrate bias generator 92 applies the substrate bias to the bias-applied portion 93.

The substrate bias generator 92 generates a substrate bias configured so as not to allow the upper limit of the operating frequency for the bias-applied portion 93 to be smaller than a predetermined value under condition of the temperature detected by the temperature sensor 91. The substrate bias generator 92 applies the generated substrate bias to the bias-applied portion 93. The upper limit of the operating frequency for the bias-applied portion 93 is comparable to the maximum frequency capable of a predetermined operation for the bias-applied portion 93 and varies with the temperature.

### Operation of the basic example

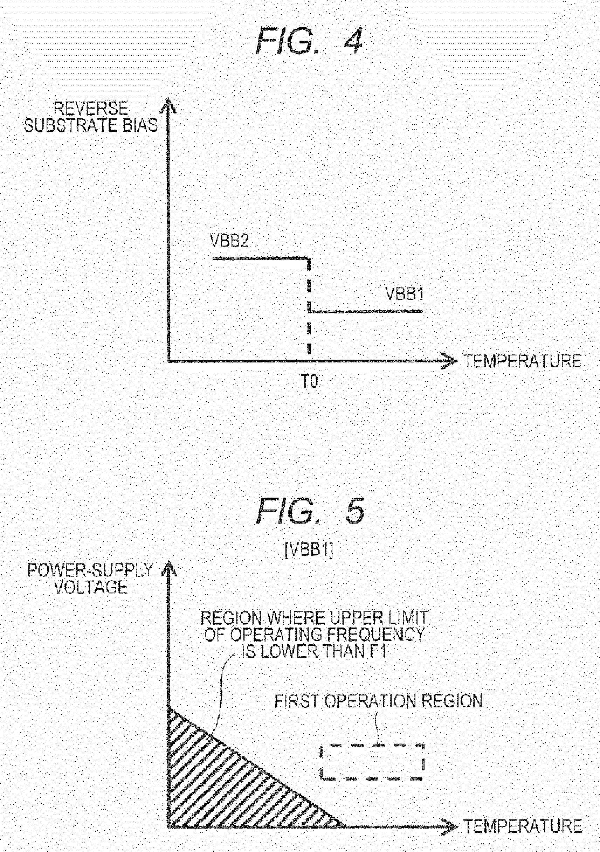

With reference to FIGS. 4 through 6, the description below explains an example operation of the semiconductor device 90 according to the basic example. The following assumes that F1 signifies a predetermined operating frequency for the bias-applied portion 93 and the bias-applied portion 93 is applied with a reverse substrate bias (a voltage lower than ground voltage VSS as a source voltage). While the following description concerns the NMOS transistor, the PMOS transistor uses the reverse substrate bias comparable to a voltage higher than power supply voltage VDD as a source voltage.

As illustrated in FIG. 4, the substrate bias generator 92 applies substrate bias VBB1 to the bias-applied portion 93 when the temperature detected by the temperature sensor 91 is higher than threshold temperature T0. When the temperature is lower than or equal to T0, the substrate bias generator 92 applies substrate bias VBB2 larger than (or smaller than in a negative direction) substrate bias VBB1 to the bias-applied portion 93.

When the temperature is higher than T0 as illustrated in FIG. 5, for example, the bias-applied portion 93, while applied with substrate bias VBB1, operates in a first operation region at the high-temperature side. However, suppose the temperature decreases while substrate bias VBB1 remains applied to the bias-applied portion 93. The operation region then overlaps a region (shaded in the drawing, the same applied to the description below) where the upper limit of the operating frequency for the bias-applied portion 93 is lower than F1. The bias-applied portion 93 may not be able to operate at the predetermined operating frequency F1.

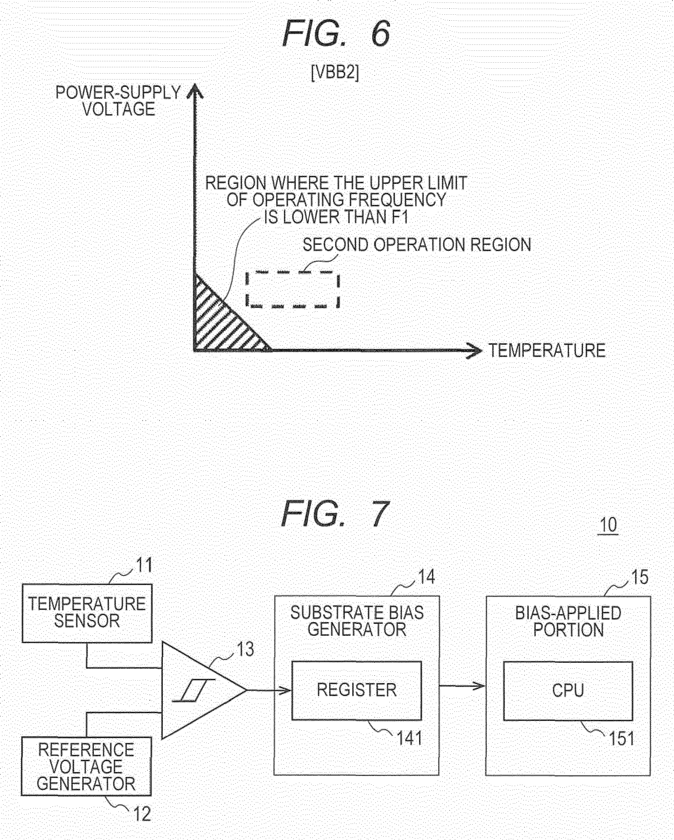

When the temperature becomes lower than or equal to T0, the substrate bias generator 92 changes the substrate bias applied to the bias-applied portion 93 to substrate bias VBB2, as above. Consequently, as illustrated in FIG. 6, the region allowing the upper limit of the operating frequency for the bias-applied portion 93 to be lower than F1 changes so as to be reduced toward the lower temperature and the lower power supply voltage. The bias-applied portion 93 can therefore achieve operation more reliable than the operation at the predetermined operating frequency F1 even when the operation is performed in a second operation region at the low-temperature side.

It is possible to prevent the upper limit of the operating frequency for the bias-applied portion 93 from becoming lower than F1 even when substrate bias VBB1 or VBB2 is applied to the bias-applied portion 93.

### Effects of the basic example

As above, according to the basic example, the substrate bias generator 92 applies the bias-applied portion 93 with the substrate bias configured so as not to allow the upper limit of the operating frequency for the bias-applied portion 93 to be smaller than a predetermined value under condition of the temperature detected by the temperature sensor 91. The bias-applied portion 93 shifts between the operating state and the stopped state in such a state that the substrate bias generator 92 applies the substrate bias to the bias-applied portion 93. The bias-applied portion 93 can therefore prevent the upper limit of the operating frequency from becoming lower than the predetermined operating frequency even when the temperature changes in the operating state. Namely, it is possible to ensure operations of the bias-applied portion 93 at the predetermined operating frequency even when the temperature changes.

The description below explains embodiments that are more specific representations of the above-mentioned basic embodiment.

### First embodiment

### Configuration of the first embodiment

With reference to FIG. 7, the description below explains an example configuration of a semiconductor device 10 according to the first embodiment. As illustrated in FIG. 7, the semiconductor device 10 according to the first embodiment includes a temperature sensor 11, a reference voltage generator 12, a hysteresis comparator 13, a substrate bias generator 14, and a bias-applied portion 15. The temperature sensor 11, the substrate bias generator 14, and the bias-applied portion 15 correspond to the temperature sensor 91, the substrate bias generator 92, and the bias-applied portion 93 in FIG. 3, respectively. The hysteresis comparator 13 represents an example comparator.

The temperature sensor 11 detects the temperature and outputs a voltage corresponding to the detected temperature to the hysteresis comparator 13. The temperature sensor 11 is provided for the semiconductor device 10. The temperature detected by the temperature sensor 11 therefore equals the temperature of the environment where the semiconductor device 10 is installed.

The reference voltage generator 12 generates a reference voltage and outputs the generated reference voltage to the hysteresis comparator 13. The reference voltage generated by the reference voltage generator 12 corresponds to the temperature in a range between threshold temperature T1 and threshold temperature T2 (T2 > T1). Threshold temperature T1 applies to the substrate bias control when the bias-applied portion 15 operates in the first operation region toward the high-temperature side from threshold temperature T1. Threshold temperature T2 applies to the substrate bias control when the bias-applied portion 15 operates in the second operation region toward the low-temperature side from threshold temperature T2. Suppose the bias-applied portion 15 operates in an operation region at the temperature in the range between threshold temperature T1 and threshold temperature T2. Then, for example, threshold temperature T1 can be used as the threshold temperature for the substrate bias when the temperature decreases from the high-temperature side. Threshold temperature T2 can be used as the threshold temperature for the substrate bias when the temperature increases from the low-temperature side.

The hysteresis comparator 13 compares the voltage output from the temperature sensor 11 with a voltage corresponding to the reference voltage output from the reference voltage generator 12 and outputs the comparison result as a digital value to the reference voltage generator 12. Here, H is output when the voltage output from the temperature sensor 11 is higher than the reference voltage. Otherwise, L is output. The voltage output from the temperature sensor 11 corresponds to the current temperature. The reference voltage output from the reference voltage generator 12 corresponds to the temperature used as the threshold temperature under the substrate bias control. The voltage comparison performed by the hysteresis comparator 13 therefore signifies the comparison between the current temperature and the temperature used as the threshold temperature under the substrate bias control.

The threshold temperature for the substrate bias control also depends on the current operation region for the bias-applied portion 15. Specifically, the reference voltage output from the reference voltage generator 12 corresponds to the temperature in the range between threshold temperature T1 and threshold temperature T2 (T2 > T1). Based on the current temperature, the hysteresis comparator 13 determines whether the bias-applied portion 15 operates in the first operation region at the high-temperature side or in the second operation region at the low-temperature side. The hysteresis comparator 13 compares a voltage output from the temperature sensor 11 with the voltage corresponding to threshold temperature T1 when the bias-applied portion 15 operates in the first operation region toward the high-temperature side from threshold temperature T1. The hysteresis comparator 13 compares a voltage output from the temperature sensor 11 with the voltage corresponding to threshold temperature T2 when the bias-applied portion 15 operates in the second operation region toward the low-temperature side from threshold temperature T2. It is possible to prevent an output from the hysteresis comparator 13 from being unstable due to a variation in the temperature by providing the threshold temperature with an allowance equal to T2 - T1.

The substrate bias generator 14 stores a digital value output from the hysteresis comparator 13 in a register 141. As illustrated in Table 1 below, for example, the substrate bias generator 14 allows the register 141 to maintain a table configured to change the substrate bias depending on a digital value output from the hysteresis comparator 13. The substrate bias generator 14 generates a substrate bias corresponding to the digital value stored in the register 141 and the contents of the table as Table 1 and applies the generated substrate bias to the substrate region of the bias-applied portion 15.

**[Table 1]**

| COMPARATOR OUTPUT | SUBSTRATE BIAS |
|---|---|
| H | VBB1 |
| L | VBB2 |

According to Table 1, the substrate bias generator 14 generates substrate bias VBB1 when the hysteresis comparator 13 outputs a digital value comparable to H. The substrate bias generator 14 generates substrate bias VBB2 larger than (or smaller than in a negative direction) substrate bias VBB1 when the hysteresis comparator 13 outputs a digital value comparable to L.

The substrate bias generator 14 applies the substrate bias to the substrate region of the bias-applied portion 15. The bias-applied portion 15 is provided as a circuit portion that can shift between at least an operating state and a stopped state and can define an operating frequency (processing speed). The bias-applied portion 15 shifts between the operating state and the stopped state in such a state that the substrate bias generator 14 applies the substrate bias to the bias-applied portion 15. The bias-applied portion 15 can be provided as a circuit portion including circuits such as a CPU (Central Processing Unit), SRAM (Static Random Access Memory), and an analog circuit, for example. The bias-applied portion 15 is assumed to be a circuit portion that includes a CPU 151 and performs circuit operations such as data transfer, data processing, and arithmetic operations on digital values and analog values.

### Operations of the first embodiment

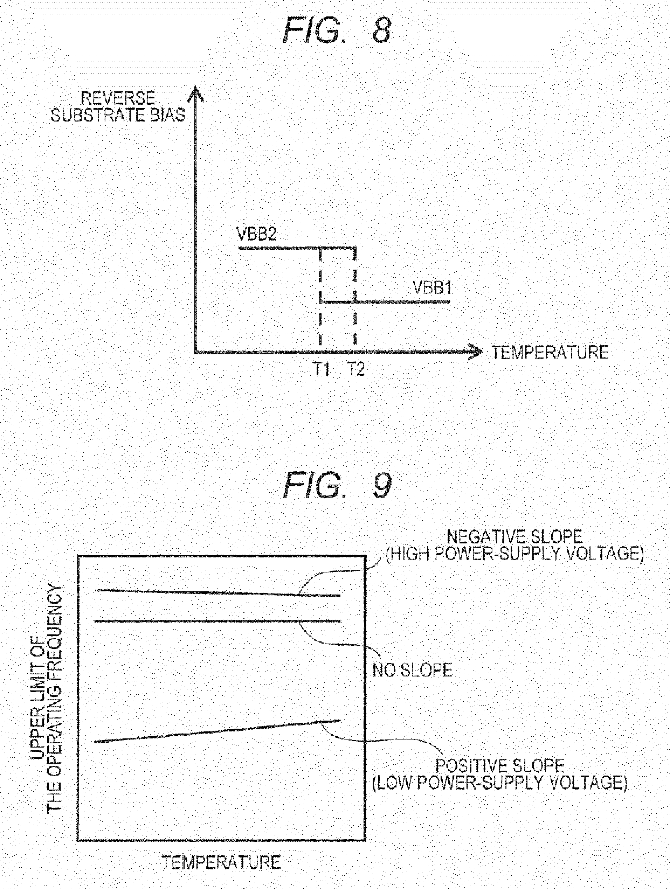

With reference to FIGS. 8 through 12, the description below explains example operations of the semiconductor device 10 according to the first embodiment. The following assumes that F1 signifies a predetermined operating frequency for the bias-applied portion 15 and the bias-applied portion 15 is applied with a reverse substrate bias (a voltage lower than ground voltage VSS as a source voltage).

The hysteresis comparator 13 compares a voltage output from the temperature sensor 11 with the voltage corresponding to threshold temperature T1 and outputs a digital value representing the comparison result when the bias-applied portion 15 operates in the first operation region toward the high-temperature side from threshold temperature T1. The hysteresis comparator 13 compares a voltage output from the temperature sensor 11 with the voltage corresponding to threshold temperature T2 and outputs a digital value representing the comparison result when the bias-applied portion 15 operates in the second operation region toward the low-temperature side from threshold temperature T2.

As illustrated in FIG. 8, the substrate bias generator 14 therefore outputs substrate bias VBB2 when the current temperature becomes lower than or equal to threshold temperature T1 while the bias-applied portion 15 operates in the first operation region at the high-temperature side. The substrate bias generator 14 outputs substrate bias VBB1 when the current temperature becomes higher than threshold temperature T2 while the bias-applied portion 15 operates in the second operation region at the low-temperature side.

The bias-applied portion 15 operates on low power supply voltage VDD1. As illustrated in FIG. 9, power supply voltage VDD1 specifically represents a low power supply voltage that gives a positive slope to the temperature dependency regarding the upper limit of the operating frequency for the bias-applied portion 15 with no substrate bias applied. Power supply voltage VDD1 is set to 1 V or lower or, more specifically, VDD1 = 0.75V, for example.

The upper limit of the operating frequency for the bias-applied portion 15 is comparable to the maximum frequency capable of a predetermined operation for the bias-applied portion 15 and varies with the temperature caused by the temperature dependency of a transistor used for the bias-applied portion 15.

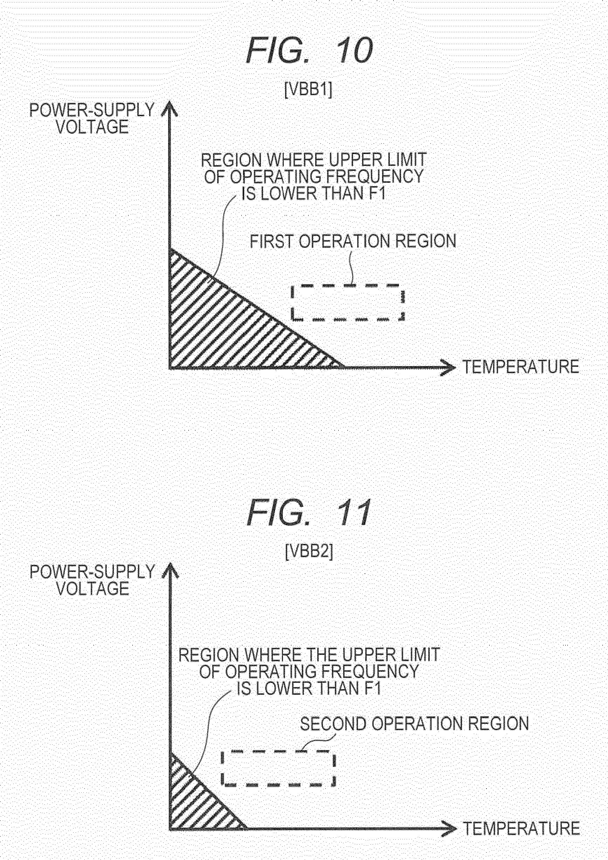

When the temperature is higher than T1 as illustrated in FIG. 10, for example, the bias-applied portion 15, while applied with substrate bias VBB1, operates in the first operation region at the high-temperature side. However, suppose the temperature decreases while substrate bias VBB1 remains applied to the bias-applied portion 15. The bias-applied portion 15 may not be able to operate at the predetermined operating frequency F1.

When the temperature becomes lower than or equal to T1, the substrate bias generator 14 changes the substrate bias applied to the bias-applied portion 15 to substrate bias VBB2, as above. Consequently, as illustrated in FIG. 11, the region allowing the upper limit of the operating frequency for the bias-applied portion 15 to be lower than F1 changes so as to be reduced toward the lower temperature and the lower power supply voltage. The bias-applied portion 15 can therefore achieve operation more reliable than the operation at the predetermined operating frequency F1 even when the operation is performed in the second operation region at the low-temperature side.

Predetermined operating frequency F1 may be set to a value in terms of production management or a data sheet and is configured as F1 = 16 MHz, for example. The substrate biases are configured as VBB1 = -1 V and VBB2 = -0.8 V, for example. Compared to VBB2, VBB1 takes effect so as to decrease the current of the transistor or increase the threshold voltage of the transistor. The substrate bias is explained as a reverse substrate bias but may be interpreted as a forward substrate bias as far as no contradiction is created. The forward substrate bias increases (in a positive direction) as the temperature decreases. The reverse direction is an expression based on an NMOS transistor. Threshold temperatures are configured as T1 = -5 °C and T2 = 0 °C, for example.

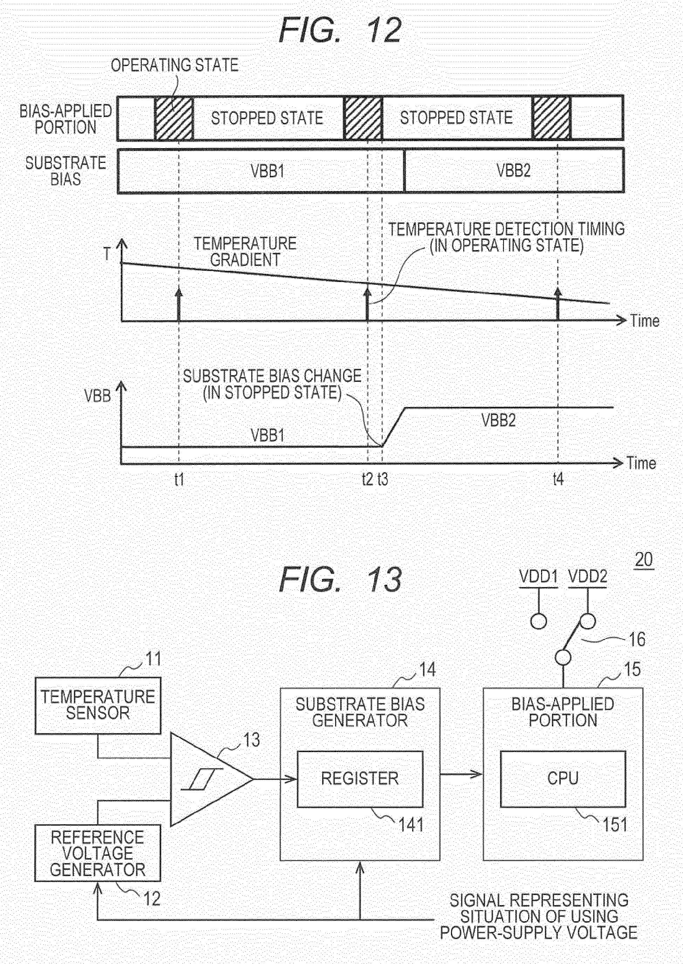

As illustrated in FIG. 12, the bias-applied portion 15 performs an intermittent operation by repeating the operating state and the stopped state. A constant substrate bias is applied to the bias-applied portion 15 when the temperature does not change during the intermittent operation. The temperature sensor 11 detects the temperature and the hysteresis comparator 13 compares the temperature while the bias-applied portion 15 enters the operating state (times t1, t2, and t4). When the substrate bias applied to the bias-applied portion 15 may need to be changed as a result of detecting and comparing the temperature at time t2, for example, the substrate bias generator 14 then starts changing the substrate bias (changing substrate bias VBB1 to VBB2 in this case) at time t3 when the bias-applied portion 15 enters the stopped state. Changing the value of a substrate bias applied to the bias-applied portion 15 in the stopped state can reduce a risk that the bias-applied portion 15 does not operate due to an effect of the temperature after shift to the operating state from the stopped state.

The first embodiment ensures operation at predetermined operating frequency F1 within the operating temperature range even when the substrate bias remains applied. The bias-applied portion 15 can repeat the operating state and the stopped state while the substrate bias remains applied. Patent literature 1 applies a substrate bias only in the stopped state in order to reduce a leakage current. The substrate bias changeover time affects the transition time to shift from the operating state to the stopped state. Contrastingly, the first embodiment applies a substrate bias even during transition from the operating state to the stopped state. The substrate bias changeover does not affect the transition time, making it possible to shorten the transition time and reduce the operating time and the operating current.

### Effects of the first embodiment

According to the first embodiment as above, the substrate bias generator 14 applies the bias-applied portion 15 with the substrate bias configured so as not to allow the upper limit of the operating frequency for the bias-applied portion 93 to be smaller than a predetermined value under condition of the temperature detected by the temperature sensor 11. The bias-applied portion 15 shifts between the operating state and the stopped state in such a state that the substrate bias generator 14 applies the substrate bias to the bias-applied portion 15. The bias-applied portion 15 can therefore prevent the upper limit of the operating frequency from becoming lower than the predetermined operating frequency even when the temperature changes in the operating state. Namely, it is possible to ensure operations of the bias-applied portion 15 at the predetermined operating frequency even when the temperature changes.

The bias-applied portion 15, while applied with the substrate bias, can shift to not only the stopped state but also the operating state even when the temperature changes. This eliminates the time to change the substrate bias during transition from the operating state to the stopped state, making it possible to shorten the operating time and reduce the overall operating current.

### Second embodiment

According to the first embodiment, the bias-applied portion 15 operates by using a single power supply voltage. According to the second embodiment, however, the bias-applied portion 15 operates by using any one of a plurality of power supply voltages. The power supply voltages are configured so that the operating frequency for the bias-applied portion 15 using at least one power supply voltage is higher than the operating frequency for the bias-applied portion 15 using the other power supply voltages. The bias-applied portion 15 is assumed to operate by using one of two power supply voltages, namely, low power supply voltage VDD1 and high power supply voltage VDD2 similarly to the first embodiment. The operating frequency for the bias-applied portion 15 using power supply voltage VDD2 is higher than that using power supply voltage VDD1.

### Configuration of the second embodiment

With reference to FIG. 13, the description below explains an example configuration of a semiconductor device 20 according to the second embodiment. As illustrated in FIG. 13, the semiconductor device 20 according to the second embodiment differs from the semiconductor device 10 according to the first embodiment in addition of a switch 16.

The switch 16 supplies power supply voltage VDD1 or VDD2 to the bias-applied portion 15. Power supply voltage VDD1 is comparable to a low power supply voltage as described in the first embodiment. Power supply voltage VDD2 is higher than VDD1 and represents a high power supply voltage that gives a negative slope (see FIG. 9) to the temperature dependency regarding the upper limit of the operating frequency for the bias-applied portion 15 with no substrate bias applied.

The bias-applied portion 15 operates by using power supply voltage VDD1 or VDD2 supplied by the switch 16.

An unshown controller supplies the reference voltage generator 12 and the substrate bias generator 14 with a control signal representing the situation of using the power supply voltage in the bias-applied portion 15 (the use of power supply voltage VDD1 or VDD2).

When the bias-applied portion 15 uses power supply voltage VDD1, the reference voltage generator 12 generates the reference voltage as described in the first embodiment and outputs the generated reference voltage to the hysteresis comparator 13.

When the bias-applied portion 15 uses power supply voltage VDD2, the reference voltage generator 12 generates a reference voltage corresponding to the temperature in the range between threshold temperature T4 and threshold temperature T3 (T3 > T4) and outputs the generated reference voltage to the hysteresis comparator 13. Threshold temperature T4 applies to the substrate bias control when the bias-applied portion 15 operates in a fourth operation region toward the high-temperature side from threshold temperature T4. Threshold temperature T3 applies to the substrate bias control when the bias-applied portion 15 operates in a third operation region toward the low-temperature side from threshold temperature T3. Suppose the bias-applied portion 15 operates in an operation region at the temperature in the range between threshold temperature T4 and threshold temperature T3. Then, for example, threshold temperature T4 can be used as the threshold temperature for the substrate bias when the temperature decreases from the high-temperature side. Threshold temperature T3 can be used as the threshold temperature for the substrate bias when the temperature increases from the low-temperature side.

The hysteresis comparator 13 performs the comparison described in the first embodiment and outputs the comparison result as a digital value to the substrate bias generator 14 when the reference voltage generator 12 outputs the reference voltage corresponding to the temperature in the range between T1 and T2.

Suppose the reference voltage generator 12 outputs the reference voltage corresponding to the temperature in the range between T3 and T4. The hysteresis comparator 13 then compares the voltage output from the temperature sensor 11 with the voltage corresponding to threshold temperature T4 when the bias-applied portion 15 operates in the fourth operation region at the high-temperature side. The hysteresis comparator 13 compares the voltage output from the temperature sensor 11 with the voltage corresponding to threshold temperature T3 when the bias-applied portion 15 operates in the third operation region at the low-temperature side. The hysteresis comparator 13 outputs the comparison result as a digital value to the substrate bias generator 14.

The substrate bias generator 14 stores a digital value output from the hysteresis comparator 13 in the register 141. As illustrated in Table 2 below, for example, the substrate bias generator 14 allows the register 141 to maintain a table configured to change the substrate bias depending on a digital value output from the hysteresis comparator 13 and a power supply voltage used by the bias-applied portion 15. The substrate bias generator 14 generates a substrate bias corresponding to the digital value stored in the register 141, the control signal value representing the situation of using the power supply voltage in the bias-applied portion 15, and the contents of the table as Table 1, and applies the generated substrate bias to the substrate region of the bias-applied portion 15.

**[Table 2]**

| POWER SUPPLY VOLTAGE | COMPARATOR OUTPUT | SUBSTRATE BIAS |
|---|---|---|
| VDD1 | H | VBB1 |
| VDD1 | L | VBB2 |
| VDD2 | L | VBB3 |
| VDD2 | H | VBB4 |

According to Table 2, the substrate bias generator 14 generates substrate bias VBB1 when the bias-applied portion 15 uses power supply voltage VDD1 and the hysteresis comparator 13 outputs a digital value comparable to H. The substrate bias generator 14 generates substrate bias VBB2 larger than (or smaller than in a negative direction) substrate bias VBB1 when the bias-applied portion 15 uses power supply voltage VDD1 and the hysteresis comparator 13 outputs a digital value comparable to L.

The substrate bias generator 14 generates substrate bias VBB3 when the bias-applied portion 15 uses power supply voltage VDD2 and the hysteresis comparator 13 outputs a digital value comparable to L. The substrate bias generator 14 generates substrate bias VBB4 larger than (or smaller than in a negative direction) substrate bias VBB3 when the bias-applied portion 15 uses power supply voltage VDD2 and the hysteresis comparator 13 outputs a digital value comparable to H.

### Operations of the second embodiment

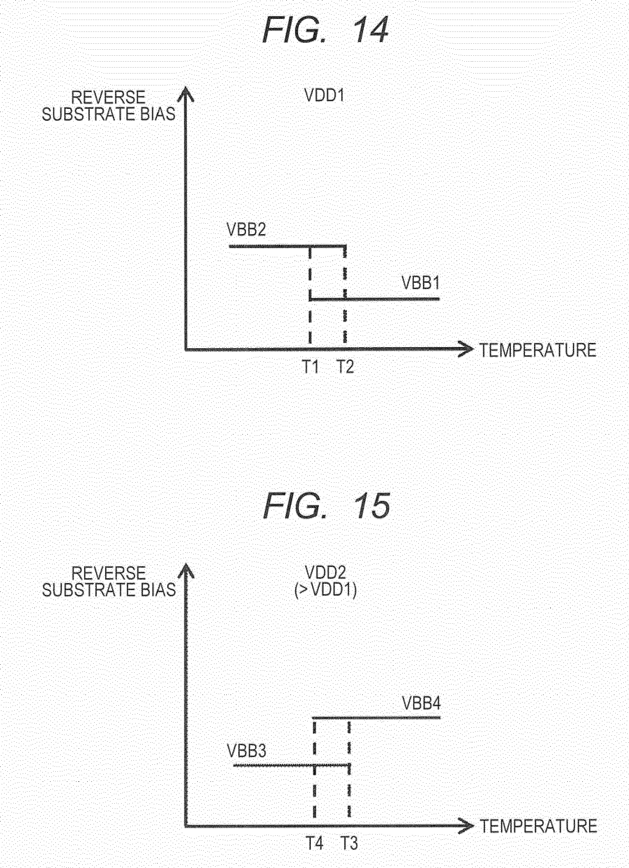

With reference to FIGS. 14 through 17, the description below explains example operations of the semiconductor device 20 according to the second embodiment. The following assumes that F1 signifies a predetermined operating frequency for the bias-applied portion 15 when using power supply voltage VDD1, F2 (F2 > F1) signifies a predetermined operating frequency for the bias-applied portion 15 when using power supply voltage VDD2, and the bias-applied portion 15 is applied with a reverse substrate bias (a voltage lower than ground voltage VSS as a source voltage).

When using power supply voltage VDD1, the bias-applied portion 15 operates similarly to the first embodiment. When using power supply voltage VDD2, the bias-applied portion 15 uses an operation region different from that used for VDD1 and increases the upper limit of the operating frequency. It is therefore possible to process the bias-applied portion 15 by increasing the operating frequency. When the bias-applied portion 15 uses VDD2, the substrate bias is designed so that the upper limit of the operating frequency for the bias-applied portion 15 does not become lower than F2 higher than F1. VDD2 attributes a negative slope to the temperature dependency concerning the upper limit of the operating frequency, providing a worst-case condition in terms of ensuring the upper limit of the operating frequency. For these reasons, the use of VDD2 necessitates performing a substrate bias control different from that performed with the use of VDD1.

The hysteresis comparator 13 performs the operation described in the first embodiment when the bias-applied portion 15 uses power supply voltage VDD1. Namely, the hysteresis comparator 13 compares a voltage output from the temperature sensor 11 with the voltage corresponding to threshold temperature T1 when the bias-applied portion 15 operates in the first operation region at the high-temperature side. The hysteresis comparator 13 compares a voltage output from the temperature sensor 11 with the voltage corresponding to threshold temperature T2 when the bias-applied portion 15 operates in the second operation region at the low-temperature side.

As illustrated in FIG. 14, the substrate bias generator 14 therefore outputs substrate bias VBB2 when the current temperature becomes lower than or equal to threshold temperature T1 while the bias-applied portion 15 uses power supply voltage VDD1 and operates in the first operation region at the high-temperature side. The substrate bias generator 14 outputs substrate bias VBB1 when the current temperature becomes higher than threshold temperature T2 while the bias-applied portion 15 uses power supply voltage VDD1 and operates in the second operation region at the low-temperature side.

The hysteresis comparator 13 compares the voltage output from the temperature sensor 11 with the voltage corresponding to threshold temperature T4 when the bias-applied portion 15 uses power supply voltage VDD2 and operates in the fourth operation region at the high-temperature side. The hysteresis comparator 13 compares the voltage output from the temperature sensor 11 with the voltage corresponding to threshold temperature T3 when the bias-applied portion 15 operates in the third operation region at the low-temperature side.

As illustrated in FIG. 15, the substrate bias generator 14 therefore outputs substrate bias VBB3 when the current temperature becomes lower than or equal to threshold temperature T4 while the bias-applied portion 15 uses power supply voltage VDD2 and operates in the fourth operation region at the high-temperature side. The substrate bias generator 14 outputs substrate bias VBB4 when the current temperature becomes higher than threshold temperature T3 while the bias-applied portion 15 uses power supply voltage VDD2 and operates in the third operation region at the low-temperature side.

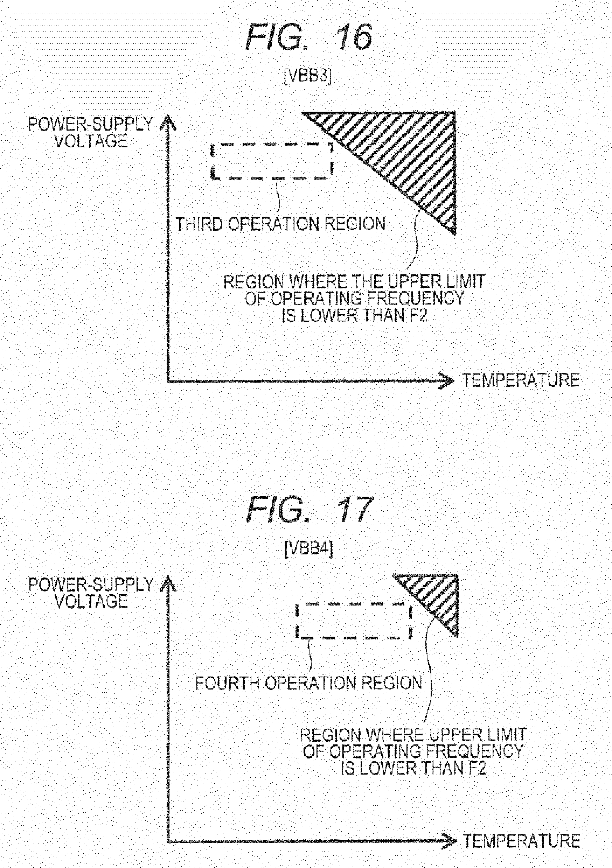

When the temperature is lower than or equal to T3 as illustrated in FIG. 16, for example, the bias-applied portion 15, while applied with substrate bias VBB3, uses power supply voltage VDD2 and operates in the third operation region at the low-temperature side. However, suppose the temperature increases while substrate bias VBB3 remains applied to the bias-applied portion 15. The bias-applied portion 15 may not be able to operate at the predetermined operating frequency F2.

When the temperature becomes higher than T3, the substrate bias generator 14 changes the substrate bias applied to the bias-applied portion 15 to substrate bias VBB4, as above. Compared to VBB3, substrate bias VBB4 takes effect so as to increase a current. Consequently, as illustrated in FIG. 17, the region allowing the upper limit of the operating frequency for the bias-applied portion 15 to be lower than F2 changes so as to be reduced toward the higher temperature and the higher power supply voltage. The bias-applied portion 15 can therefore achieve operation more reliable than the operation at the predetermined operating frequency F4 even when the operation is performed in the fourth operation region at the high-temperature side.

When using power supply voltage VDD1, the bias-applied portion 15 operates similarly to the first embodiment as described with reference to FIGS. 10 and 11 and a description is omitted.

The power supply voltage is assumed to be VDD2 = 1.1 V, for example. The substrate biases are assumed to be VBB3 = -0.3 V and VBB4 = 0 V, for example. The temperatures are assumed to be T3 = 45 °C and T4 = 40 °C, for example. The predetermined operating frequency is assumed to be F2 = 120 MHz, for example. The other conditions are equal to those in the first embodiment.

### Effects of the second embodiment

According to the second embodiment as above, the substrate bias generator 14 applies the bias-applied portion 15 with the substrate bias configured so as not to allow the upper limit of the operating frequency for the bias-applied portion 15 to be smaller than a predetermined value under condition of the temperature detected by the temperature sensor 11 and the power supply voltage used by the bias-applied portion 15. It is therefore possible to add the capability of increasing the operating frequency at a high power supply voltage to the configuration of the first embodiment that ensures low-power-consumption operations at a low power supply voltage. A high power supply voltage increases the upper limit of the operating frequency. Even in this case, the bias-applied portion 15, while applied with the substrate bias, shifts between the operating state and the stopped state. Even when the temperature changes, it is possible to secure the upper limit of the operating frequency and ensure operations at the predetermined operating frequency.

The other effects are equal to those in the first embodiment.

### Third embodiment

According to the above-mentioned first and second embodiments, the same substrate to mount the semiconductor device includes only one circuit portion (bias-applied portion) to which a substrate bias is applied. According to the third embodiment, however, the same substrate to mount the semiconductor device includes a plurality of circuit portions (bias-applied portions) to which a substrate bias is applied. The following assumes three bias-applied portions 15A, 15B, and 15C to be available.

### Configuration of the third embodiment

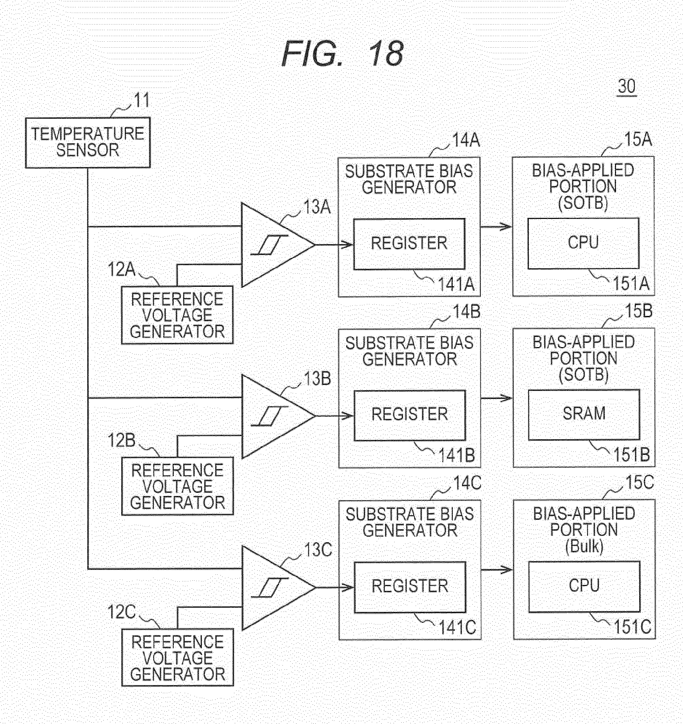

With reference to FIG. 18, the description below explains an example configuration of a semiconductor device 30 according to the third embodiment. As illustrated in FIG. 18, the semiconductor device 30 according to the third embodiment differs from the semiconductor device 10 according to the first embodiment in provision of three sets of the reference voltage generator 12, the hysteresis comparator 13, the substrate bias generator 14, and the bias-applied portion 15.

Namely, the third embodiment provides three bias-applied portions 15A, 15B, and 15C as circuit portions (bias-applied portions) to which a substrate bias is applied.

A transistor based on the SOTB (Silicon on Thin Buried Oxide) structure is available as a device that makes the substrate bias control particularly effective. The SOTB is one type of SOI (Silicon on Insulator). With reference to FIG. 1C, the SOTB uses a thin insulating film (20 nm or thinner) referred to as BOX (Buried Oxide) between a silicon substrate (pSUB) and a silicon layer used as the channel of a transistor. The SOTB-structure transistor therefore particularly excels at producing the effect of substrate bias control.

At least one of the bias-applied portions 15A, 15B, and 15C advantageously includes a circuit using the SOI-structure transistor and more advantageously includes a circuit using the SOTB-structure transistor. The bias-applied portion 15A is assumed to include a CPU 151A using the SOTB-structure transistor. The bias-applied portion 15B is assumed to include an SRAM 151B using the SOTB-structure transistor. The bias-applied portion 15C is assumed to include a CPU 151C using a bulk-structure transistor.

The bias-applied portions 15A, 15B, and 15C are each provided with reference voltage generators 12A, 12B, and 12C, hysteresis comparators 13A, 13B, and 13C, substrate bias generators 14A, 14B, and 14C, respectively. The substrate bias control to apply a substrate bias is performed on the bias-applied portions 15A, 15B, and 15C independently of each other. The bias-applied portions 15A, 15B, and 15C share the temperature sensor 11.

As described in the above-mentioned first and second embodiments, decreasing the temperature decreases the upper limit of the operating frequency when the bias-applied portions 15A, 15B, and 15C use low power supply voltages and remain applied with the substrate bias. The upper limit of the operating frequency differently varies with devices.

For example, suppose the upper limit of the operating frequency decreases with the substrate bias or the temperature more remarkably in the SRAM 151B than in the CPU 151A. In such a case, the threshold temperature (comparable to T1) from high to low temperatures in the bias-applied portion 15B including the SRAM 151B is configured to be higher than the threshold temperature (comparable to T1) from high to low temperatures in the bias-applied portion 15A including the CPU 151A. For this purpose, the reference voltage generators 12A and 12B are designed to output reference voltages that differ from each other. Alternatively, the substrate bias generators 14A and 14B may be designed to apply substrate biases that are sized differently from each other. In this case, registers 141A and 141B are designed so as to be configured differently from each other.

The CPU 151C using a bulk-structure transistor is also characterized differently from the CPU 151A or the SRAM 151B using the SOTB-structure transistor in terms of substrate biases or temperatures. The bias-applied portion 15C including the CPU 151C is also designed as above.

### Operations of the third embodiment

In the third embodiment, operations of the reference voltage generators 12A, 12B, and 12C, the hysteresis comparators 13A, 13B, and 13C, the substrate bias generators 14A, 14B, and 14C, and the bias-applied portions 15A, 15B, and 15C are equal to the operations of the reference voltage generator 12, the hysteresis comparator 13, the substrate bias generator 14, and the bias-applied portion 15 according to the first embodiment, respectively, and a description is omitted.

### Effects of the third embodiment

As above, the third embodiment provides the reference voltage generators 12A, 12B, and 12C, the hysteresis comparators 13A, 13B, and 13C, the substrate bias generators 14A, 14B, and 14C for each of a plurality of bias-applied portions 15A, 15B, and 15C to which a substrate bias is applied. The substrate bias control can be therefore performed on a plurality of bias-applied portions 15A, 15B, and 15C independently of each other.

The other effects are equal to those in the first embodiment.

Examples of the application of the embodiments

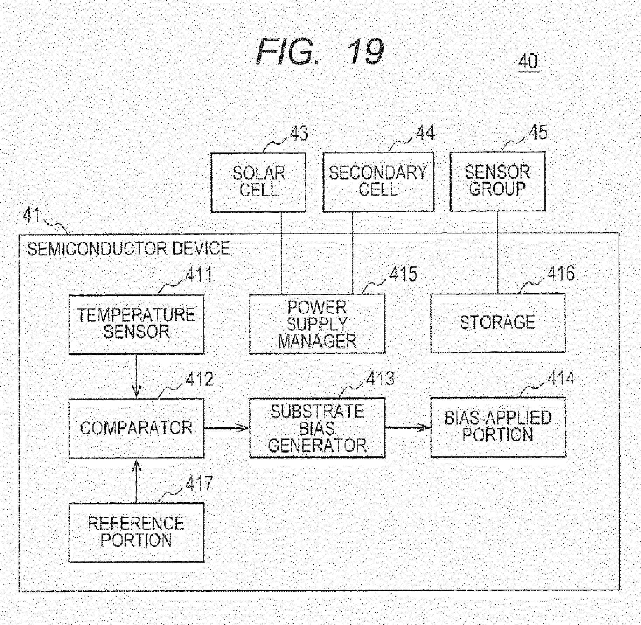

With reference to FIG. 19, the description below explains an example configuration of a semiconductor device 40 as an application of the semiconductor device according to the above-mentioned embodiments. As illustrated in FIG. 19, the sensor terminal 40 according to the present example includes a semiconductor device 41 corresponding to the semiconductor device according to the above-mentioned embodiments, a solar cell 43, a secondary cell 44, and a sensor group 45.

The semiconductor device 41 uses the solar cell 43 and the secondary cell 44 as power supplies and acquires sensor data from the sensor group 45. The sensor group 45 includes various sensors such as an acceleration sensor, an optical sensor, and a barometric pressure sensor.

The semiconductor device 41 includes a temperature sensor 411, a reference portion 417, a comparator 412, a substrate bias generator 413, and a bias-applied portion 414 corresponding to the temperature sensor 11, the reference voltage generator 12, the hysteresis comparator 13, the substrate bias generator 14, and the bias-applied portion 15, respectively, according to the above-mentioned embodiments. In addition, the semiconductor device 41 includes a power supply manager 415 and a storage 416. The power supply manager 415 manages power interchange with the solar cell 43 and the secondary cell 44. The storage 416 stores sensor data from the sensor group 45. The reference portion 417 outputs a signal concerning the temperature as the threshold temperature assumed by the substrate bias control to the comparator 412. The reference portion 417 stores the threshold temperature for the substrate bias control so that a system builder can rewrite the threshold temperature.

The sensor terminal 40 can be used as a wearable appliance attached to an arm, glasses, and clothes, for example. The sensor terminal 40 is particularly effective in situations that require attachment of the appliance under an environment subjected to temperature change. As a wearable appliance, the sensor terminal 40 is attached to a mountain-climbing user, for example. During the mountain climbing, the semiconductor device 41 acquires biological information and environmental information as sensor data from the sensor group 45 and stores the information in the storage 416. The biological information includes the amount of activity, an oxygen level in the blood, and a blood pressure, for example. The environmental information includes an air temperature and an atmospheric pressure, for example. The sensor group 45 can directly or indirectly measure the biological information and the environmental information.

According to the present example, the semiconductor device 41 can ensure operation of the CPU included in the bias-applied portion 414 without lowering the predetermined operating frequency even when the altitude gradually increase and the ambient temperature decreases during the mountain climbing. In this case, the operation of the CPU included in the bias-applied portion 414 is important because the CPU acquires sensor data from the sensor group 45 during the mountain climbing and performs specified arithmetic operations based on the acquired sensor data. The semiconductor device 41 is provided as a low-power-consumption semiconductor device operating on a low power supply voltage. The electric power during the mountain climbing can be therefore supplied from the fully charged secondary cell 44. The sufficient solar light may be available and the solar cell 43 may be able to supply sufficient power to the semiconductor device 41. In such a case, the power supply manager 415 may control this power and may charge the secondary cell 44 using this power.

Moreover, the sensor terminal 40 can be attached to a shipping container and can detect an abnormal vibration or damage. The shipping container may be placed outdoors or in a low-temperature depository and is therefore subjected to large temperature change. Similarly to the above-mentioned wearable appliance, the sensor terminal attached to the shipping container therefore needs to periodically acquire sensor data from the sensor group 45 and extend the life of the solar cell 43 and the secondary cell 44.

### Example of setting the reference voltage

The semiconductor device 10 according to the above-mentioned first embodiment settles the threshold temperature for the substrate bias control corresponding to the reference voltage generated by the reference voltage generator 12.

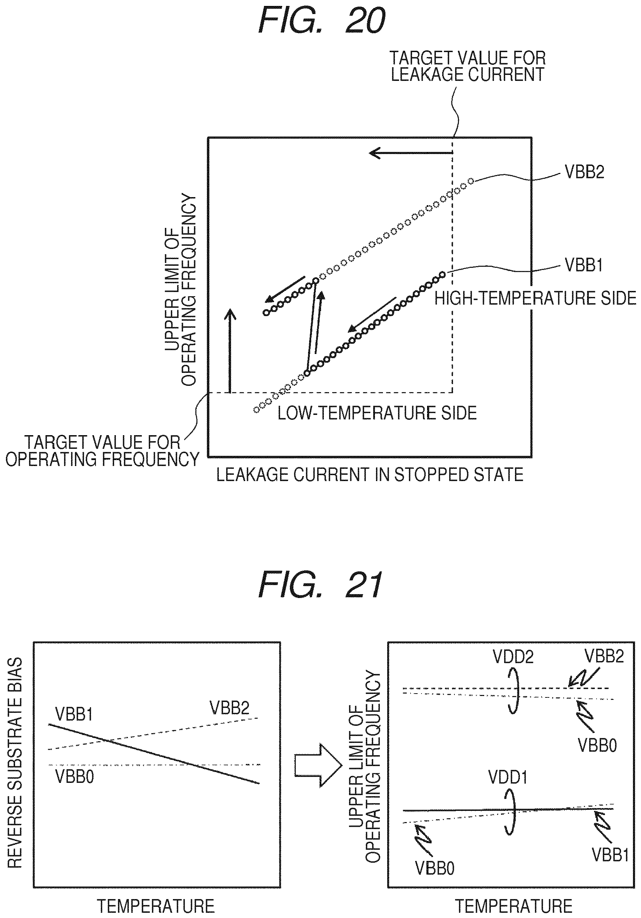

With reference to FIG. 20, the description below explains an example of setting the reference voltage generated by the reference voltage generator 12. The example uses target values for the upper limit of the operating frequency in the operating state of the bias-applied portion 15 and a leakage current in the stopped state thereof and aims at satisfying the target values in the operating temperature range.

In the example illustrated in FIG. 20, the temperature is changed while applying a given substrate bias to the bias-applied portion 15, and the upper limit of the operating frequency in the operating state and a leakage current in the stopped state is plotted each time the temperature is changed. The substrate bias is changed subsequently and the same plot operation is performed each time the substrate bias is changed. The example selects a combination of substrate biases capable of shift from the high-temperature side to the low-temperature side (and from the low-temperature side to the high-temperature side) at the specified temperature (threshold temperature) under the condition that satisfies the above-mentioned two target values.

According to the example in FIG. 20, the two states of substrate biases VBB1 = -1 V and VBB2 = -0.8 V shift from the high-temperature side to the low-temperature side at threshold temperature T1 = -5 °C under the condition that the operating frequency is set to be higher than or equal to 16 MHz in the operating state of the bias-applied portion 15 and the leakage current is set to be smaller than or equal to 1 µA in the stopped state thereof. It is therefore possible to settle the reference voltage generated by the reference voltage generator 12 based on threshold temperature T1.

### Modifications of the embodiments

In all the above-mentioned embodiments, the hysteresis comparator 13 determines the two states, namely, whether the current temperature belongs to the high-temperature side or the low-temperature side. Therefore, there are provided two types of substrate biases to be applied to the bias-applied portion 15 so that the substrate bias varies with either of the two states. However, the substrate biases are not limited thereto. Namely, three or more types of substrate biases may be applied to the bias-applied portion 15.

The temperature sensor 11 may output a voltage (or a current) varying with the current temperature. The substrate bias generator 14 may apply a substrate bias varying with the output from the temperature sensor 11 to the bias-applied portion 15. This configuration may provide control that keeps the upper limit of the operating frequency for the bias-applied portion 15 constant with respect to the temperature.

With reference to FIG. 21, the description below explains a modification of the substrate bias control according to the above-mentioned first and second embodiments, namely, an example of performing control that keeps the upper limit of the operating frequency for the bias-applied portion 15 constant with respect to the temperature. As illustrated in FIG. 2, the example assumes the following three types of substrate biases to be applied to the bias-applied portion 15.
(A) substrate bias VBB0: set to be constant regardless of the temperature
(B) substrate bias VBB1: set to decrease as the temperature rises
(C) substrate bias VBB2: set to increase as the temperature rises

For example, suppose the bias-applied portion 15 operates on low power supply voltage VDD1 as described in the first embodiment. In this case, applying substrate bias VBB0 gives a positive slope to the temperature dependency regarding the upper limit of the operating frequency for the bias-applied portion 15. However, applying substrate bias VBB1 keeps the upper limit of the operating frequency for the bias-applied portion 15 almost constant regardless of the temperature.

Suppose the bias-applied portion 15 operates on high power supply voltage VDD2 as described in the second embodiment. In this case, applying substrate bias VBB0 gives a negative slope to the temperature dependency regarding the upper limit of the operating frequency for the bias-applied portion 15. However, applying substrate bias VBB2 keeps the upper limit of the operating frequency for the bias-applied portion 15 almost constant regardless of the temperature.

Accordingly, the above-mentioned control method can also allow the bias-applied portion 15 to prevent the upper limit of the operating frequency from becoming lower than the predetermined operating frequency when the temperature changes in the operating state. Namely, it is possible to ensure operations of the bias-applied portion 15 at the predetermined operating frequency even when the temperature changes.

The above-mentioned control method is also applicable to a configuration such as the second embodiment that changes the power supply voltage for the bias-applied portion 15.

While there have been described the specific embodiments of the invention made by the inventors, it is to be distinctly understood that the present invention is not limited to the above-mentioned embodiments and may be embodied in various modifications without departing from the spirit and scope of the invention.

For example, the above-mentioned embodiments provide the internal composition elements of the semiconductor device as hardware. It is also possible to provide all or part of the internal composition elements of the semiconductor device as software such as a program read from the memory. In this case, the semiconductor device can be configured as a computer including a processor such as a CPU to perform arithmetic processes or control processes and a memory to store programs or various data read and executed by the processor. It is therefore understood by those skilled in the art that the internal composition elements can be provided in various forms such as only the hardware, only the software, and a combination of these. The present invention is not limited thereto.

The above-mentioned program is stored by using various types of non-transitory computer readable medium and can be supplied to computers. The non-transitory computer readable medium includes various types of tangible storage medium. Examples of the non-transitory computer readable medium include magnetic recording media (such as flexible disks, magnetic tape, and hard disks), optical magnetic recording media (such as optical magnetic disks), CD-ROM (compact disc read only memory), CD-R (compact disc recordable), CD-R/W (compact disc rewritable), and semiconductor memory (such as mask ROM, PROM (programmable ROM), EPROM (erasable PROM), flash ROM, and RAM (random access memory)). The program may be supplied to computers through various types of transitory computer readable medium. Examples of the transitory computer readable medium include electric signals, optical signals, and electromagnetic waves. The transitory computer readable medium can supply the program to computers via wired communication paths such as electric wires and optical fibers or wireless communication paths.

## Claims

1. A semiconductor device comprising:
a bias-applied portion applied with a substrate bias;
a temperature sensor that detects a temperature; and
a substrate bias generator that applies a substrate bias corresponding to a temperature detected by the temperature sensor to the bias-applied portion,
wherein the bias-applied portion, while applied with the substrate bias by the substrate bias generator, shifts between an operating state and a stopped state; and
wherein the substrate bias generator applies the bias-applied portion with the substrate bias configured so as not to cause an upper limit of an operating frequency for the bias-applied portion to be smaller than a predetermined value under condition of a temperature detected by the temperature sensor.

2. The semiconductor device according to claim 1, further comprising:
a switch that supplies the bias-applied portion with one of a plurality of power supply voltages,
wherein the substrate bias generator applies the bias-applied portion with the substrate bias configured so as not to cause an upper limit of an operating frequency for the bias-applied portion to be smaller than a predetermined value under condition of a temperature detected by the temperature sensor and a power supply voltage used by the bias-applied portion.

3. The semiconductor device according to claim 2,
wherein the bias-applied portion causes an operating frequency used with at least one of the power supply voltages to be higher than an operating frequency used with other power supply voltages.

4. The semiconductor device according to claim 1, further comprising:
a comparator that compares a temperature detected by the temperature sensor with a threshold temperature,
wherein the substrate bias generator applies the bias-applied portion with the substrate bias varying with a comparison result from the comparator.

5. The semiconductor device according to claim 4,
wherein the comparator is assigned a first threshold temperature and a second threshold temperature higher than the first threshold temperature as the threshold temperature;
wherein the comparator compares a temperature detected by the temperature sensor with the first threshold temperature when the bias-applied portion operates in an operation region toward a high-temperature side from the first threshold temperature; and
wherein the comparator compares a temperature detected by the temperature sensor with the second threshold temperature when the bias-applied portion operates in an operation region toward a low-temperature side from the second threshold temperature.

6. The semiconductor device according to claim 1,
wherein the substrate bias generator applies the bias-applied portion with the substrate bias varying with a temperature detected by the temperature sensor.

7. The semiconductor device according to claim 1,
wherein the substrate bias generator changes, as needed, the substrate bias to be applied to the bias-applied portion when the bias-applied portion remains a stopped state.

8. The semiconductor device according to claim 1,
wherein a plurality of the substrate bias generators are provided correspondingly to the bias-applied portions, if any, and
wherein each of the substrate bias generators applies the substrate bias to the corresponding bias-applied portion independently of each other.

9. The semiconductor device according to claim 1,
wherein at least one of the bias-applied portions includes a circuit using a transistor based on an SOI (Silicon on Insulator) structure.

10. The semiconductor device according to claim 9,
wherein the SOI-structure transistor includes a buried oxide layer whose thickness is less than or equal to 20 nm.

11. The semiconductor device according to claim 1,
wherein the substrate bias is provided as a reverse substrate bias.

12. The semiconductor device according to claim 1,
wherein the bias-applied portion uses a power supply voltage that attributes a negative slope to temperature dependency concerning an upper limit of an operating frequency in the bias-applied portion.

13. A sensor terminal comprising:
a semiconductor device described in claim 1; and
a sensor group that outputs sensor data to the semiconductor device,
wherein the bias-applied portion includes a circuit that performs specified arithmetic operation based on sensor data output from the sensor group.

14. A method of controlling a semiconductor device including a bias-applied portion applied with a substrate bias, comprising:
detecting a temperature;
applying the bias-applied portion with the substrate bias configured so as not to cause an upper limit of an operating frequency for the bias-applied portion to be smaller than a predetermined value under condition of the detected temperature; and
causing the bias-applied portion, while applied with the substrate bias, to shift between an operating state and a stopped state.
